# EUROPEAN PATENT APPLICATION

(11) **EP 3 923 309 A1**
(43) Date of publication of application: **15.12.2021**
(21) Application number: 20179688.5
(22) Date of filing: 12.06.2020
(51) Int. Cl.: H01H 11/00, G05B 23/02, G01R 31/327, H01H 33/70

(54) **PROVISION OF CURRENTLY UNMEASURABLE STATE INFORMATION ABOUT A SWITCHGEAR DEVICE SYSTEM**

(71) Applicant: ABB Power Grids Switzerland AG, 5400 Baden (CH)
(72) Inventor: MATTEI, Stefano, 8006 Zürich (CH); LEHMANN, Joerg, 4056 Basel (CH); KIEFERNDORF, Frederick, 5400 Baden (CH); LOPEZ, Sergio, 2493 WG, The Hague (CH); ZIMMERMANN, Esteban, 8047 Zürich (CH)
(74) Representative: Michalski Hüttermann & Partner Patentanwälte mbB

(57) **Abstract**

The invention relates to a digital twin system (1) for providing currently unmeasurable state information about a switchgear device system, wherein the switchgear device system comprises at least one switchgear device (2), of which a state and/or control parameter of at least one switchgear device component is sensed and/or controlled, wherein the digital twin system (1) comprises at least one digital twin (3), and wherein each of the digital twin (3) comprises communication means being connectable, for receiving data about the state and/or the control parameter of the at least one switchgear device component or of the at least one switchgear device (2); and calculation means, configured to determine at least one currently unmeasurable state of the at least one switchgear device component and/or of the switchgear device system, using the at least one system model, based on the data about the state and/or the control parameter.

## Description

### Technical Field

The invention relates to a digital twin system for providing currently unmeasurable state information about a switchgear device system, wherein the switchgear device system comprises at least one switchgear device, of which a state and/or control parameter of at least one switchgear device component is sensed and/or controlled. The present invention also relates to a digital twin method for providing currently unmeasurable state information about a circuit breaker system, wherein the switchgear device system comprises at least one switchgear device, of which a state and/or control parameter of at least one switchgear device component is sensed and/or controlled. The invention further relates to a storage medium with the computer program comprising according steps to carry out the method.

### Background Art

Switchgear devices are used to control, protect and isolate electronic equipment. The determination of states in a switchgear device is essential to determine, for example, whether there is a defect in the switchgear device, currently or in the imminent future, and whether the switchgear device is still operating reliably.

Digital twins are used to simulate or otherwise mimic the operation of such switchgear devices within a virtual world, in particular by virtually displaying structural components of the switchgear devices. Such way digital wins can be considered as a digital representation of the such switchgear devices.

### Summary of invention

It is an object of the invention to provide an improved digital twin. It is especially an object of the present invention to provide currently unmeasurable state information about a switchgear device system, whereby especially currently unmeasurable state information should be provided with limited implementation or installation effort also for most existing switchgear devices.

The object of the invention is solved by the features of the independent claims. Modified embodiments are detailed in the dependent claims.

Thus, the object is solved by a digital twin system for providing currently unmeasurable state information about a switchgear device system. The switchgear device system comprises at least one switchgear device, of which a state and/or control parameter of at least one switchgear device component is sensed and/or controlled. The digital twin system comprises at least one digital twin. Each of the digital twins comprises communication means being connectable, via a data exchange connection, to and/or from the at least one switchgear device of the switchgear device system, for receiving data about the state and/or the control parameter of the at least one switchgear device component or of the at least one switchgear device; storage means comprising at least one system model, which is in accordance with the state and/or the control parameter; and calculation means, configured to determine at least one currently unmeasurable state of the at least one switchgear device component and/or of the switchgear device system, using at least one system model, based on the data about the state and/or the control parameter.

Currently unmeasurable state information refers to any information about a state of the switchgear device. The information can be about a condition that is technically not measurable or only very difficult or difficult to measure with effort or, e.g. due to disproportionate additional costs. The information can refer to a state which is in the future or which is a current state, for example occurring due to an operating state of the switchgear device.

The switchgear device may be a medium voltage switchgear device or a high voltage switchgear device. Medium voltage refers to a voltage range from 600V to 69 kV. High voltage refers to a voltage range of equal to/more than 69 kV. The switchgear device may be a gas-insulated switch gear device. The switchgear device may be a circuit breaker. A circuit breaker makes and breaks all currents within the scope of its ratings, which includes small inductive and capacitive load currents up to the full short circuit current. The circuit breaker may make and break currents under all fault conditions in the power supply system, such as earth faults, or phase opposition.

The digital twin is appropriate for being used for circuit breaker technology. The circuit breaker may be any circuit breaker, such as a vacuum circuit breaker, a gas circuit breaker, or a generator circuit breaker.

The switchgear device may be a switch configured to switch currents up to its rated normal operating current and make on existing short circuits up to its rated short circuit making current. The switchgear device may be applied for a medium to high voltage switchgear.

A digital twin is a partial or total digital replica of a physical device. The physical device may be replicated in a simplified way or in a sophisticated way taking into account any parameters which influence the operation of the physical device. A digital twin is based on modelling a device/system including any data which may be relevant for modelling the physical device as realistically as necessary. Such data may be one of/some of/all of: geometrical data, kinematic functionality and logical and/or physical behaviour of the physical device, wherein digital tools are used. The digital twin may refer directly to the physical device/system and may allow it to either one of/more of/all of: being simulated, controlled or improved. For example, the physical behaviour may refer to electrodynamic and/or fluid dynamic and/or thermodynamic processes

For example, the digital twin may operate/the method according to the invention may be carried out in a continuous way. For example, the digital twin may operate/the method according to the invention may be carried out at defined intervals in a discrete mode, for example by providing a data point every minute or hour, if no operation in the physical device takes place. Alternatively, the digital twin may operate/the method may be carried out during an operation of the physical device, for example. Furthermore, it may be an option to carry out offline/online monitoring. Furthermore, the digital twin may operate/the method according to the invention may be carried out for providing objectives.

The storage means may comprise or be an external storage, an internal storage, or a combination thereof. For example, an external storage may comprise/be a cloud.

The system model is used to determine currently not measurable parameters or states in the system. For example, the system model may be determined on the basis of a state/control parameter. The control parameter may be, for example, a motor driving current in a certain range. According to this motor driving current range, the system model may be selected. Another example may be a certain voltage range, in which the switch device is operating, so that the system model may be selected according to the voltage range. Alternatively, the system model may be selected based only on parameters/states which have been obtained from the system, that means without taking into account a range of the parameter/state.

The invention also relates to a digital twin method for providing currently unmeasurable state information about a switchgear device system. The switchgear device system comprises at least one switchgear device, of which a state and/or control parameter of at least one switchgear device component is sensed and/or controlled. The digital twin system comprises at least one digital twin. The method comprises the following steps:

According to a first step, the method comprises receiving, by communication means via a data exchange connection between the at least one twin device and at least one switchgear device of the switchgear device system, data about the state and/or the control parameter of the at least one switchgear device component or of the at least one switchgear device. This step may be, for example, useful for continuous monitoring of the device system and for quickly determining critical states. Furthermore, based on the received data, lifetime simulation may be carried out, for example.

According to a further step, the method comprises determining, by calculation means, at least one currently unmeasurable state of the at least one switchgear device component and/or of the switchgear device system, using at least one system model in accordance with the state and/or the control parameter.

Additionally, the method may comprise steps according to features of any of the modified embodiments of the system.

The object is also solved by a computer-readable storage medium comprising instructions which, when executed by a computer, cause the computer to carry out the steps of the method.

The method described above is a computer-implemented method that can be implemented entirely on a computer, or that is implemented in conjunction with switchgear devices. The computer system could be either installed on the device, it could be run remotely, or there could be provided a combination thereof.

It is a key point of the invention to enhance possibilities to monitor internal states of switch devices over its lifetime. The invention overcomes the issue that only a lack of data to perform tasks such as condition monitoring exists due to the limited number of sensors that can be installed.

The invention provides a digital twin of an electric switchgear device, such as a circuit breaker, providing a digital representation of a potential/physical breaker unit with the possibility to introduce input field data. With the advent of digital control of circuit breakers, such as by motor-drives, together with the availability of sophisticated simulation models there can be provided a digital twin that mimics the real device behaviour in a digital framework. This allows providing a detailed imitation of the internal state of an operating device virtually, providing access to previously inaccessible information. At a basic level, a digital twin receives data about the state and/or the control parameter, such as sensor data, from a field device, such as motor-drive currents, or from a hydro-mechanical drive with linear sensor or from a spring drive with a rotational sensor, and synthetically calculates unavailable internal parameters applying a detailed system model of the breaker actuator, linkage and chambers. On a more complex level, a master central digital twin could also actuate as a central system that collects and updates system model data from digital twins which are controlled accordingly, e.g. by commands of the master digital twin.

The invention reduces premature failures of switch devices and unobserved component degradation. Furthermore, appropriate, or optimal maintenance intervals can be realized enhancing the system performance. Thereby, operating and maintenance cost can be reduced, and customers are more satisfied.

According to a modified embodiment, of the received data, the state is of operational relevance for the at least one switchgear device. In other words, the received data comprises data about the state, wherein the state is of operational relevance for the at least one switchgear device. The state may be any measurable physical state. For example, the state comprises one of: a component position, component speed, gas composition in a component tank, temperature, pressure, ambient temperature, humidity. These exemplarily mentioned states can be determined with little effort and with sensors being already used in the switchgear devices. Thus, there is no effort when upgrading with twin systems in an existing system with at least one switchgear device. The component position can be a rotor position of a motorized switch device, for example. Alternatively, it can be an actuator position of the switchgear device. The component speed can be a rotational speed of a rotor of a motor driven switchgear device. For example, the gas composition can be measured by means of a sensor in a gas chamber of a gas circuit breaker. Pressure and temperature can also be properties of the gas in the last described gas chamber or, for example, of the motor of the motorized switchgear device. The states mentioned above are only examples and are not to be understood as limiting to the modified embodiment.

According to a modified embodiment, of the received data, the control parameter is relevant to the application of the at least one switchgear device. In other words, the received data comprises data about the control parameter, wherein the control parameter is relevant to the application of the at least one switchgear device. For example, the control parameter may comprise one of: component operating voltage, component operating current, switchgear device voltage, switchgear device current.

The switchgear device voltage/current may refer to the voltage/current, for which the switchgear device operates as a safety device. For example, in case of a circuit breaker, such voltage/current value is the value for which the circuit breaker provides security against too high loads. Additionally, depending on the application, the control parameter comprises one of: a component position, component speed, gas composition in a component tank, temperature, pressure. These exemplarily mentioned control parameters can be determined with little or no effort, partially also without sensors or with sensors already used in the switchgear devices. Thus, there is no effort when upgrading with twin systems in an existing system with at least one switchgear device. The control parameters mentioned above are only examples and are not to be understood as limiting to the modified embodiment.

According to a modified embodiment, the at least one currently unmeasurable state comprises one of: an operation relevant state obtained from the state and/or the control parameter of the received data, an application relevant control parameter obtained from the state and/or the control parameter of the received data. For example, the at least one currently unmeasurable state may comprise one of: a switchgear device component wear state, component stress, component friction, a condition in an area of the switchgear device which is caused by an operation in the switchgear device, thermal conditions. Such a condition in an area caused by an operation in the switchgear device may be a gas composition in a circuit breaker chamber. All these conditions are conditions that are difficult, or unreliably measured or can only be measured with enormous time and effort. Therefore, a cost-effective and well implementable method can be provided for the determination of these states. For example, a condition in an area of the switchgear device which is caused by an operation in the switchgear device may be a critical extension of an arc within the switchgear device components suffer a higher amount of wear reducing their lifetime. Furthermore, thermal conditions may refer, for example, to thermal parameters of heat dissipators of the switchgear device, such as a circuit breaker. The currently unmeasurable states mentioned above are only examples and are not to be understood as limiting to the modified embodiment.

According to a modified embodiment, the communication means is connected to the at least one switchgear device via the data exchange connection. The type of connection, for example permanent or only in certain time intervals, may be selected according to requirements of the kind of switchgear device system. A permanent data connection would have the advantage that the twin system could permanently determine states in the switchgear device system and thus quickly identify critical states. A temporary connection is also conceivable, e.g. action-controlled if an event is detected on the switchgear device system, such as an excessively high peak voltage.

According to a modified embodiment, the data about the state and/or control parameter is provided by at least one of: the switchgear device component, sensing means being installed at the switchgear device, a calculation, a simulation of a component operation, a simulation of a switchgear device operation. For example, one way of determining the data may be based on the reliability of a source for providing the data. The system can also choose the way the data is determined based on a state in the switch device/switch device system. This allows flexible and demand-oriented data determination.

According to a modified embodiment, the system model is adapted to emulate/emulates properties of the switchgear device, with a degree of complexity of the system model and/or of an estimator, wherein the properties are at least one of: a functioning of at least one switchgear device component; and/or a structure of the switchgear device, and/or an interaction between individual components of the switchgear device, and/or conditions in areas of the switchgear device, which are caused by operations of the switchgear device components. The degree of complexity of the system model can span a wide range from a complete emulation to a very simplified emulation. A determination of a state of only one component with the system model would be conceivable, for example, in the presence of less computing capacity or a reduction in connection quality for the transmission of data, for example if it is a switchgear device that is mobile and cannot always access a fixed data connection. It may also be appropriate if the system contains, for example, a component that is particularly sensitive/system-critical/wear-prone and other components of the system are negligible, for example because they are not so important for the functionality of the system or are very unlikely to fail.

According to a modified embodiment, the system model is adapted to emulate/emulates the properties of at least one of:
- the switchgear device with full complexity of the system model and/or of the estimator,
- the switchgear device with reduced complexity of the system model and/or of the estimator,
- the switchgear device component with full complexity of the system model and/or of the estimator,
- the switchgear device component with reduced complexity of the system model and/or of the estimator.

According to an example of this above-described modified embodiment, the system model is adapted to emulate/emulates the properties of the switchgear device or of the at least one switchgear device component with full complexity of the system model and/or of the estimator. This has the advantage that a complete image of the system can be made available. Such a possibility is of particular advantage for a most realistic prediction of the lifetime of a switchgear device or to identify which (chain) processes in a switchgear device can cause critical states.

According to an example of this above-described modified embodiment, the system model is adapted to emulate/emulates the properties of the at least one switchgear device component with full complexity of the system model and/or of the estimator and at least one of the switchgear device component with reduced complexity of the system model and/or of the estimator. A reduced order model may reflect a simplification of a higher order model, to simplify its complexity and still reflect the relevant dynamics. "Reduced order" could also refer to determining which properties of the switchgear device are needed to estimate the states of interest, rather than all of the states. "Reduced order" could also mean that the simulation model is simplified in its description of a particular component, for example by considering only the dynamics in a particular "subspace" of the full system space. "Reduced order" could mean that only those components of the switchgear device that are typically susceptible to wear or maintenance are simulated. Also, only those components that are necessary for the functionality of the switchgear device actuator could be simulated. Such modified embodiment can provide a detailed view on the system considering that some properties of the switchgear device do not need to be emulated on such a detailed level, thereby reducing computation amount.

According to an example of this above-described modified embodiment, the system model is adapted to emulate/emulates the properties of the switchgear device with reduced complexity of the system model and/or of the estimator. Such a kind of determination by a system model can be useful to enable fast, possibly time-simultaneous determination of states in complex systems with many switchgear devices. The state determination can be more effective if the behaviour of the system, including interaction between components, is already fully known.

According to a modified embodiment, the system model comprises an aging model for calculating a lifetime of at least one switchgear device component and/or of the switchgear device. For example, statistical data can be used to determine a lifetime. The statistical data are preferably available over a longer period of time for one device and especially preferably over a longer period of time for a large number of devices of one or more systems. Setting a lifetime for a component or the device can help to plan maintenance cycles for the device/system.

According to a modified embodiment, the system model comprises/is a simplified estimator for determining the currently unmeasurable state of at least one switchgear device component and/or of the switchgear device. A simplified estimator provides a simplified approximation on the currently unmeasurable state. For example, for providing this approximation, the state of less or not influencing components of the device or artefacts in the data may be neglected. Alternatively, or additionally, state-less components, such as the components not having energy storing capacity or not being relevant for dynamics to be estimated may be neglected. Alternatively, or additionally, data collected within a time period may be used for the approximation instead of using data which has been provided during the whole measurement time. For example, it is possible that periods of time are known in which maintenance work was carried out and in which measurement data is available from a switchgear device, which would be useless for an estimator. Alternatively, or additionally, the simplified estimator may be an estimator that uses only a short a priori measurement window and not all the a priori measurements. In case of a system model being an estimator, the simplified estimator may be a simplified system model, which could be of full order or of reduced order.

According to a modified embodiment, the system model comprises/is an efficient estimator for determining the currently unmeasurable state of at least one switchgear device component and/or of the switchgear device. The estimator, which is efficient, refers to a statistic with small variances. Inefficient estimators can as well, but such estimators usually require much larger samples.

According to a modified embodiment, the system model comprises stored data. The data can originate from the device that is monitored via the twin system. A supply of data could also be possible, for example to train a system model for specific states of the system/devices/component.

According to a modified embodiment, the system comprises storing means for storing historical data about the state and/or the control parameter. For example, the historical data may be provided from one device or from multiple devices. This enables, for example, the twin system to operate independently of a data connection via which data is transmitted. By historical data, internal wear conditions can be better estimated, especially using a history of faults.

According to a modified embodiment, the communication means is configured to receive/receives the historical data from external storage means. The historical data can originate from the device that is monitored via the twin system. A supply of data could also be possible, for example to train a system model for specific states of the system/devices/com ponent.

According to a modified embodiment, the calculation means is configured to determine/determines the at least one currently unmeasurable state of the at least one component and/or at least one currently unmeasurable state of the switchgear device system, using the selected system model, based on the data about the state and/or the control parameter and based on historical data about the state and/or the control parameter. A combination of several data types can improve the accuracy of the determination.

According to a modified embodiment, the calculation means is configured to correlate/correlates the at least one currently unmeasurable state with a state to be expected, or the calculation means is configured to correlate the at least one currently unmeasurable state with the state to be expected using a measured state. This improves detecting and quantifying a deviation from certain conditions.

According to a modified embodiment, the measured state is provided by multiple switchgear devices. In other words, it can be used to monitor the status of several devices in a system. Also, more data can be collected, which in turn improves statistical analysis.

According to a modified embodiment, based on a result of the comparison, the calculation means is configured to generate/generates a control signal to be forwarded by the communication means to the switchgear device. The control signal may serve for changing any of the operations within the switchgear device. For example, it may have been determined as a result of the comparison that there is a friction variation over time within one device, or a change of the wear conditions over time.

According to a modified embodiment, the control signal is adapted to modify a control parameter of the switchgear device. For example, the control signal may make the switchgear device change at least one of the currents in an actuator motor drive. The control parameter could serve to improve an operating mechanism or actuator mechanism, or a point of an electric current waveform, where the actuator is actuated.

According to a modified embodiment, based on a result of the comparison, the calculation means is configured to provide/provides data about the state and/or the control signal to be forwarded by the communication means to a human machine interface (HMI) for displaying information on the component state or a switchgear device state. This may serve to notify about critical conditions in the device/system and/or to indicate an essential maintenance of the device/system.

According to a modified embodiment, based on a result of the comparison, a contact time of the breaker of the switchgear device is determined. This could serve for a better accuracy in the contact system state which may extend the electrical lifetime of the breaker. For example, the control reference may be adjusted to ensure adequate breaking times. Furthermore, determining the contact time of the breaker allows planning maintenance, wherein a better planning reduces the time that the breaker is out of operation.

According to a modified embodiment, based on the determined currently unmeasurable state, the calculation means is configured to carry out/carries out a statistical analysis. This could also serve for further planning of maintenance of the device/system or for improving lifetime simulations of the system.

According to a modified embodiment, based on the determined currently unmeasurable state, the calculation means is configured to provide/provides a predictive maintenance plan. This has the advantage that failures of the device/system can be more effectively avoided.

According to a modified embodiment, based on the determined currently unmeasurable state, the communication means is configured to provide/provides the currently unmeasurable state to an external calculation means for carrying out the statistical analysis. This can be advantageous in order to have access to more computing capacity.

According to a modified embodiment, based on the determined currently unmeasurable state, the communication means is configured to provide/provides the currently unmeasurable state to an external calculation means for machine learning.

According to a modified embodiment, the digital twin system is one centralized digital twin master system being assigned to multiple switchgear devices. For example, the central twin system can receive all information from other twin systems and process it centrally. The central twin system can also receive data being already processed by the other twin systems, such as certain unmeasurable states. Thus, the central twin system can also compare and evaluate the operations of the other twin systems and optimize them. For example, systematic errors can also be detected and corrected.

According to a modified embodiment, the centralized digital twin master system being assigned to the multiple switchgear devices is configured to update/updates or to add/adds further system models to enhance emulation capabilities of the digital twin systems.

According to a modified embodiment, the switchgear device system comprises at least two switchgear devices, of which respectively a state of at least one switchgear device component is sensed and/or controlled. According to a modified embodiment, the digital twin system comprises at least two digital twins. According to a modified embodiment, each of the digital twins is assigned to a single switchgear device to determine currently unmeasurable states of the single switchgear device. A combination of the advantageous designs described above can be used as part of a system with a central twin device. Irrespective of whether the modified versions described above are used in combination with the central twin system, the pairwise assignment of twin device and switchgear device results in 1-to-1 monitoring of the switchgear devices, in which the switchgear devices can be simulated 1-to-1. Thus, for example, errors that only occur through interaction of many switchgear devices in a common system can be detected more easily.

According to a modified embodiment, the twin device system comprises the switchgear device system.

Further embodiments and advantages of the method are directly and unambiguously derived by the person skilled in the art from the system as described before.

### Brief description of drawings

These and other aspects of the invention will be apparent from and elucidated with reference to the embodiments described hereinafter.

In the drawings:
- Fig. 1: schematically shows a system model of a digital twin system according to an embodiment; and
- Fig. 2: shows a flow chart of a method according to an embodiment.

### Description of embodiments

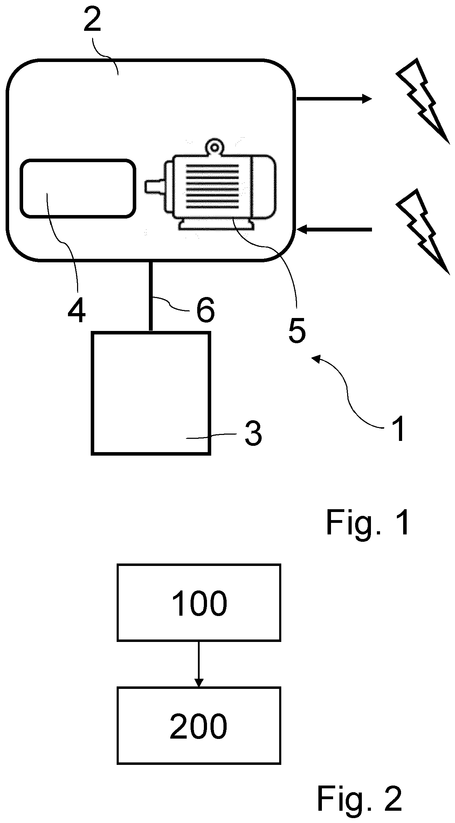

Fig. 1 schematically shows a system model of a digital twin system 1 according to an embodiment. The system 1 comprises a switchgear device 2 and a digital twin 3. The switchgear device 2 comprises a breaker chamber 4 and a motor 5. The digital twin 3 is connected to the switchgear device 2 via a data connection 6. The switchgear device 2 according to the embodiment is a circuit breaker.

The functioning of the digital twin 3, according to this embodiment, is as follows:
The digital twin 3 receives as an input sensor data and/or calculated data. Such data may refer to motor-drive currents of the motor 5 or the torque of the motor 5, for example, or to measurements of a hydro-mechanical drive with a linear sensor or of a spring drive with a rotational sensor. Subsequently, the digital twin 3 simulates a system operation based on a system model of the of the switchgear device 2 and provides as output information about the internal states of the switchgear device 2.

The system model may comprise a software architecture (not depicted).

According to an exemplary application of the system model according to the embodiment, breaker operation open-close-open (O-C-O) and motor-drive currents are given as input to the digital twin 3 together with stored historical data. The historical data may be provided from previous operations, for example. Then, the digital twin 3 processes the system model that synthetically generates information about the breaker internal states, such as nozzle wear. Subsequently, relevant output data is compared to expected operations of the circuit breaker. The relevant output data can be used for any of the following purposes: adaptation of system parameters, such as friction of the main contact as input to a feedforward controller; adaptation of control system references, such as the optimized control reference; triggering alarms in case of critical deviations, for example, deviations from the travel curve; uploading data to a database for statistical analysis, in order to carry out predictive maintenance; providing data to a Human Machine Interface (HMI) displaying information about the breaker state; identifying a contact time.

In other embodiments, the digital twin can consist of sets of pre-simulated output data and a circuit breaker internal state can be inferred from the best match with measured data.

Examples of system models used within the digital twin 3 can be a detailed system model for simulating an electric circuit, drive, linkage and interrupter, and a breaker chamber including an arc model based on plasma physics (not depicted). Alternatively, the digital twin 3 can be simulated with reduced-order models based on full scale simulations, aging models, simplified estimators, stored data, or a combination thereof.

Fig. 2 shows a flow chart of a method according to an embodiment.

According to a step indicated by the reference number "100", the method comprises receiving, by communication means (not depicted) via a data exchange connection (corresponding to the data connection 6 in Fig. 1) between the at least one twin device 3 and at least one switchgear device 2 of the switchgear device system, data about the state and/or the control parameter of the at least one switchgear device component or of the at least one switchgear device 2.

According to a step indicated by the reference number "200", the method comprises determining, by calculation means, at least one currently unmeasurable state of the at least one switchgear device component and/or of the switchgear device system, using at least one system model in accordance with the state and/or the control parameter.

Further improvements can be achieved by gathering data from several field devices and including their statistical behaviour to improve the digital twin response. In a similar scenario one can envisage a centralized digital twin master that receives info from several devices and updates its behaviour to all followers, and subsystems alike.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: digital twin system
- 2: switchgear device
- 3: digital twin
- 4: breaker chamber
- 5: motor
- 6: data connection
- 100: receiving, by communication means via a data exchange connection between the at least one twin device and at least one switchgear device of the switchgear device system, data about the state and/or the control parameter of the at least one switchgear device component or of the at least one switchgear device
- 200: determining, by calculation means, at least one currently unmeasurable state of the at least one switchgear device component and/or of the switchgear device system, using at least one system model in accordance with the state and/or the control parameter

## Claims

1. A computer-implemented digital twin method for providing currently unmeasurable state information about a switchgear device system,
wherein the switchgear device system comprises at least one switchgear device (2), of which a state and/or control parameter of at least one switchgear device component is sensed and/or controlled,
wherein the digital twin system (1) comprises at least one digital twin (3), the method comprising the steps of:
receiving (100), by communication means via a data exchange connection between the at least one twin device (3) and at least one switchgear device (2) of the switchgear device system, data about the state and/or the control parameter of the at least one switchgear device component or of the at least one switchgear device (2),
determining (200), by calculation means, at least one currently unmeasurable state of the at least one switchgear device component and/or of the switchgear device system, using at least one system model in accordance with the state and/or the control parameter.

2. The method according to the preceding claim,
wherein of the received data, the state is of operational relevance for the at least one switchgear device (2); or
wherein of the received data, the control parameter is relevant to the application of the at least one switchgear device (2); or
wherein the at least one currently unmeasurable state comprises one of: an operation relevant state obtained from the state and/or the control parameter of the received data, an application relevant control parameter obtained from the state and/or the control parameter of the received data.

3. The method according to any of the preceding claims,
wherein the data about the state and/or control parameter is provided by at least one of: the switchgear device component, sensing means being installed at the switchgear device (2), a calculation, a simulation of a component operation, a simulation of a switchgear device operation.

4. The method according to any of the preceding claims,
wherein the system model emulates properties of the switchgear device (2), with a degree of complexity of the system model and/or of an estimator, wherein the properties are at least one of:
- a functioning of at least one switchgear device component; and/or
- a structure of the switchgear device (2), and/or
- an interaction between individual components of the switchgear device (2), and/or
- conditions in areas of the switchgear device (2), which are caused by operations of the switchgear device components; and/or
wherein the system model comprises an aging model for calculating a lifetime of at least one switchgear device component and/or of the switchgear device (2); and/or
wherein the system model comprises/is a simplified estimator for determining the currently unmeasurable state of at least one switchgear device component and/or of the switchgear device (2); and/or
wherein the system model comprises/is an efficient estimator for determining the currently unmeasurable state of at least one switchgear device component and/or of the switchgear device (2); and/or
wherein the system model comprises stored data.

5. The method according to any of the preceding claims,
wherein the communication means provides historical data about the state and/or the control parameter from storage means; or
wherein the calculation means determines the at least one currently unmeasurable state of the at least one component and/or at least one currently unmeasurable state of the switchgear device system, using the selected system model, based on the data about the state and/or the control parameter and based on historical data about the state and/or the control parameter.

6. The method according to any of the preceding claims,
wherein the calculation means correlates the at least one currently unmeasurable state with a state to be expected, or
wherein the calculation means correlates the at least one currently unmeasurable state with the state to be expected using a measured state; or
wherein multiple switchgear devices (2) provide the measured state.

7. The method according to the preceding claim,
wherein, based on a result of the comparison, the calculation means generates a control signal to be forwarded by the communication means to the switchgear device (2), or
wherein the control signal is adapted to modify a control parameter of the switchgear device (2); or
wherein the control signal is adapted to modify a control system reference; or wherein, based on a result of the comparison, the calculation means provides data about the state and/or the control signal to be forwarded by the communication means to a human machine interface, HMI, for displaying information on the component state or a switchgear device state; or
wherein, based on a result of the comparison, a contact time of the breaker of the switchgear device (2) is determined.

8. The method according to any of the preceding claims,
wherein, based on the determined currently unmeasurable state, the calculation means carries out a statistical analysis; or
wherein, based on the determined currently unmeasurable state, the calculation means provides a predictive maintenance plan; or
wherein, based on the determined currently unmeasurable state, the communication means provides the currently unmeasurable state to an external calculation means for carrying out the statistical analysis; or
wherein, based on the determined currently unmeasurable state, the communication means provides the currently unmeasurable state to an external calculation means for machine learning.

9. A computer-readable storage medium comprising instructions which, when executed by a computer, cause the computer to carry out the steps of the method of any of the preceding claims.

10. A digital twin system (1) for providing currently unmeasurable state information about a switchgear device system,
wherein the switchgear device system comprises at least one switchgear device (2), of which a state and/or control parameter of at least one switchgear device component is sensed and/or controlled,
wherein the digital twin system (1) comprises at least one digital twin (3), and wherein each of the digital twin (3) comprises
communication means being connectable, via a data exchange connection, to and/or from the at least one switchgear device (2), for receiving data about the state and/or the control parameter of the at least one switchgear device component or of the at least one switchgear device (2);
storage means comprising at least one system model, which is in accordance with the state and/or the control parameter; and
calculation means, configured to determine at least one currently unmeasurable state of the at least one switchgear device component and/or of the switchgear device system, using the at least one system model, based on the data about the state and/or the control parameter.

11. The system (1) according to the preceding system claim,
wherein the communication means is connected to the at least one switchgear device (2) via the data exchange connection; or
the system comprising storing means for storing historical data about the state and/or the control parameter.

12. The system (1) according to any of the preceding system claims,
wherein the switchgear device system comprises at least two switchgear devices (2), of which respectively a state of at least one switchgear device component is sensed and/or controlled, and
wherein the digital twin system (1) comprises at least two digital twins (3), or wherein each of the digital twins (3) is assigned to a single switchgear device (2) to determine currently unmeasurable states of the single switchgear device (2), or
the digital twin system (1) being one centralized digital twin master system being assigned to multiple switchgear devices (2).

13. The system (1) according to the preceding system claim,
wherein the centralized digital twin master system being assigned to the multiple switchgear devices (2) is configured to update or to add further system models to enhance emulation capabilities of the digital twin systems (1) according to any of claims 9 to 11

14. The system (1) according to any of the preceding system claims, comprising the switchgear device system.
